# DEMANDE DE BREVET EUROPEEN

(11) **EP 1 239 711 A1**
(43) Date de publication de la demande: **11.09.2002**
(21) Numéro de dépôt: 02290549.1
(22) Date de dépôt: 06.03.2002
(51) Int. Cl.: H05K 5/00, H05K 7/20

(54) **Boîtier électronique sans couvercle d'ouverture**

(30) Priorité: 09.03.2001 FR 0103246
(71) Demandeur: VALEO ELECTRONIQUE, 94042 Creteil Cédex (FR)
(72) Inventeur: Thiollay, Lionel, 91600 Savigny sur Orge (FR)
(74) Mandataire: Prugneau, Philippe

(57) **Abrégé**

Le boîtier électronique comprend un boîtier support métallique (CH) fermé de façon étanche, un circuit imprimé (CI) muni de composants électroniques (CP) inséré à l'intérieur du boîtier support et un intercalaire thermique disposé entre le circuit imprimé et une face intérieure du boîtier support, le circuit imprimé est plaqué contre ladite face intérieure du boîtier support par au moins une vis de telle manière que la chaleur produite par les composants électroniques puisse être transférée par conduction thermique du circuit imprimé (CI) vers le boîtier support par l'intermédiaire de l'intercalaire thermique (IT). Dans ce boîtier, chaque vis (VF) est insérée dans le circuit imprimé depuis l'extérieur du boîtier support, et chaque vis traverse de façon étanche ladite face intérieure du boîtier. Avec cet agencement, le boîtier ne comprend pas de couvercle, ce qui permet de réduire son coût de fabrication.

## Description

L'invention concerne un boîtier électronique comprenant un boîtier support métallique fermé de façon étanche, un circuit imprimé muni de composants électroniques inséré à l'intérieur du boîtier support et un intercalaire thermique disposé entre le circuit imprimé et une face intérieure du boîtier support, le circuit imprimé étant plaqué contre ladite face intérieure du boîtier support par au moins une vis de telle manière que la chaleur produite par les composants électroniques puisse être transférée par conduction thermique du circuit imprimé vers le boîtier support par l'intermédiaire de l'intercalaire thermique.

L'invention s'applique plus particulièrement aux boîtiers électroniques destinés à être installés dans un environnement sévère comme par exemple les boîtiers de régulation de suspension équipant certains véhicules automobiles.

Dans un tel boîtier électronique connu de l'art antérieur, le circuit imprimé est fixé à la face intérieure du boîtier support par des vis accessibles depuis l'intérieur du boîtier support. Le boîtier support est donc muni d'une ouverture qui peut être fermée de façon étanche par un couvercle. L'étanchéité est assurée par un joint placé entre le couvercle et l'ouverture du boîtier support. Le couvercle est fixé au boîtier support par plusieurs vis.

Le but de l'invention est de simplifier la structure d'un tel boîtier électronique en réduisant notamment le nombre de pièces nécessaires pour la fixation du circuit imprimé sur la face intérieure du boîtier support. Un autre but de l'invention est de réduire le coût de fabrication et de montage d'un tel boîtier électronique.

A cet effet, l'invention a pour objet un boîtier électronique comprenant un boîtier support métallique fermé de façon étanche, un circuit imprimé muni de composants électroniques inséré à l'intérieur du boîtier support et un intercalaire thermique disposé entre le circuit imprimé et une face intérieure du boîtier support, le circuit imprimé étant plaqué contre ladite face intérieure du boîtier support par au moins une vis de telle manière que la chaleur produite par les composants électroniques puisse être transférée par conduction thermique du circuit imprimé vers le boîtier support par l'intermédiaire de l'intercalaire thermique, caractérisé en ce chaque vis est insérée dans le circuit imprimé depuis l'extérieur du boîtier support, chaque vis traversant de façon étanche ladite face intérieure du boîtier.

Avec cette construction, on évite la présence d'un couvercle ce qui permet de réduire le coût de production par réduction du nombre de pièces primaires. Chaque vis est donc mise en place depuis l'extérieur du boîtier support pour venir tirer (ou plaquer) le circuit imprimé contre la face intérieur du boîtier support.

Selon un mode de réalisation particulier du boîtier électronique selon l'invention, chaque vis est insérée dans un insert métallique fileté fixé audit circuit imprimé. De la sorte, chaque vis peut être serrée suffisamment fort pour garantir un bon plaquage du circuit imprimé contre le boîtier support ce qui contribue à améliorer la conduction thermique entre le circuit imprimé et le boîtier support.

Selon encore un autre mode de réalisation particulier du boîtier électronique selon l'invention, le boîtier support comprend au moins une nervure interne positionnée dans un plan perpendiculaire à ladite face intérieure du boîtier support, chaque nervure étant agencée pour guider ledit circuit imprimé de telle manière à le plaquer contre ladite face intérieure quand il est inséré dans ledit boîtier support. Avec cet agencement, lorsque le circuit est inséré dans le boîtier support, il est prépositionné par rapport à celui-ci, pour faciliter l'implantation des vis de fixation dans le circuit imprimé ou dans les inserts métalliques filetés.

L'invention sera maintenant décrite plus en détail ci-après et illustrée sur les dessins annexés.
La figure 1 est une représentation d'un boîtier de l'art antérieur ;
La figure 2 est une vue en perspective du boîtier selon l'invention démonté;
La figure 3 est une vue en coupe du boîtier selon l'invention assemblé.

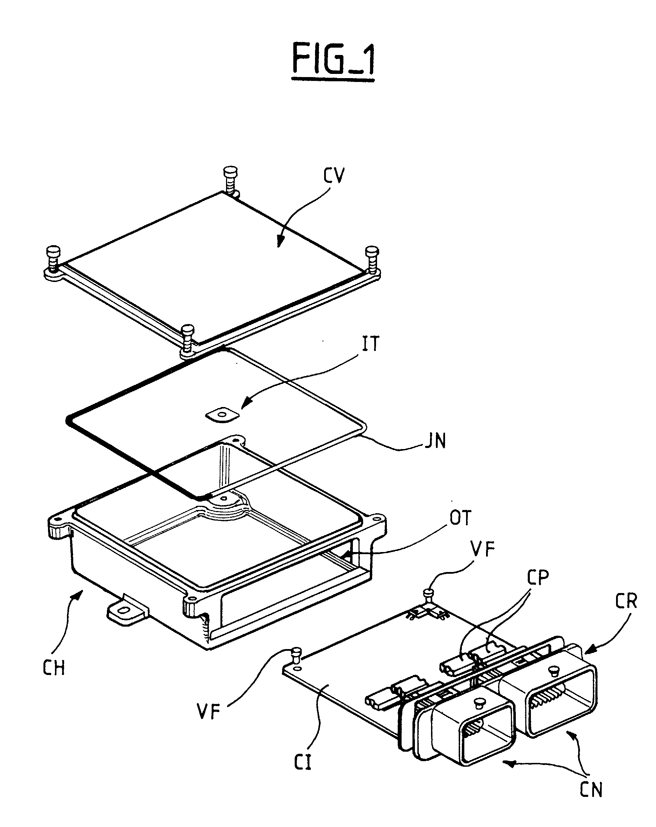

Dans l'art antérieur, de tels boîtiers comprennent par exemple un boîtier support CH de forme sensiblement parallélépipédique, fermé par un couvercle CV comme représenté dans la figure 1. Ce couvercle CV est monté sur le boîtier support au moyen de quatre vis, et une étanchéité est réalisée par exemple avec un joint JN qui s'étend sur le pourtour du couvercle et qui est comprimé entre le couvercle et le boîtier support. Ce boîtier support comprend encore une ouverture OT sur l'une de ses faces destinée à recevoir un circuit imprimé Cl qui s'insère latéralement dans le boîtier par l'ouverture OT à la manière d'un tiroir. Lors de l'assemblage, le circuit imprimé Cl est d'abord inséré, avant d'être vissé sur le boîtier au moyen de vis de fixation VF qui sont montées depuis l'intérieur du boîtier qui est accessible lorsque le couvercle est démonté. Ce couvercle est ensuite monté pour terminer l'assemblage. Plus particulièrement, les vis VF plaquent la plaque de silicium du circuit imprimé sur une face intérieure du boîtier support, en étant vissées dans des filetages du boîtier support prévus à cet effet et en traversant le circuit imprimé au niveau de trous qu'il comprend. Des intercalaires thermique IT sont généralement disposés entre le circuit imprimé et le boîtier support CH, au niveau des vis de fixation, pour favoriser une bonne conduction thermique entre le circuit et le boîtier support. Le circuit imprimé Cl qui est équipé de composants électroniques CP supporte également des connecteurs CN qui sont solidaires d'un capot CR monté perpendiculairement au plan du circuit imprimé et longeant un bord de celui-ci, et qui s'emboîte dans l'ouverture OT tout en réalisant avec celle-ci une liaison étanche.

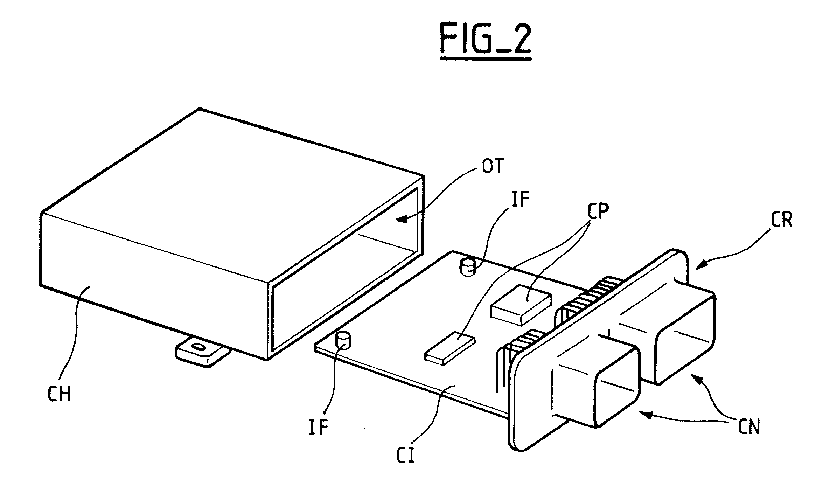

Le boîtier selon l'invention, qui est représenté dans la figure 2 a également une forme sensiblement parallépipédique, mais il ne comprend pas de couvercle d'ouverture. Son boîtier support est doté d'une seule ouverture OT destinée à recevoir latéralement le circuit imprimé Cl. Ce circuit imprimé reçoit les filetages de vis de fixation qui sont alors montées depuis l'extérieur du boîtier support. Plus particulièrement, des trous sont prévus dans le boîtier support CH pour être traversés par les vis de fixation VF, qui peuvent ainsi se visser dans le circuit imprimé Cl. De cette façon, un opérateur peut d'abord insérer latéralement le circuit imprimé Cl par l'ouverture latérale OT, puis visser les vis de fixation VF depuis l'extérieur du boîtier pour plaque le circuit imprimé à sa face intérieure. Ainsi, le nombre d'opérations de montage est réduit par rapport aux boîtiers de l'art antérieur. Dans le boîtier selon l'invention, le circuit imprimé est donc tiré par serrage des vis de fixation sur le boîtier support, alors que dans l'art antérieur, le circuit imprimé était poussé sur le boîtier support lors du serrage des vis de fixation. L'étanchéité au niveau des vis de fixation pourra être réalisée grâce à des rondelles telles que des rondelles en matière plastique.

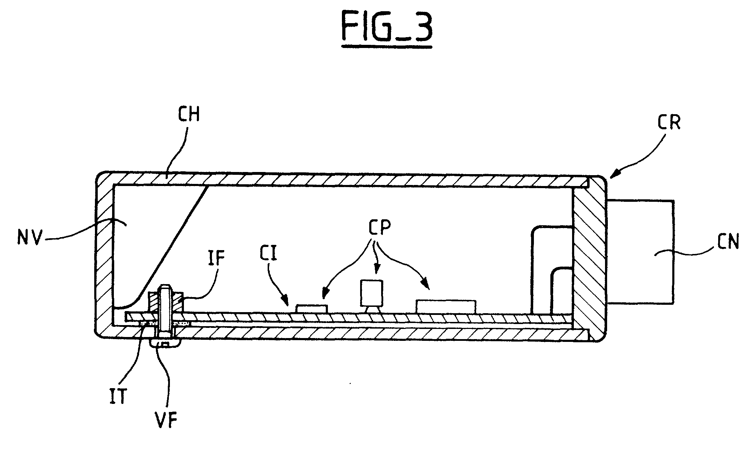

En variante, comme représenté dans la vue en coupe de la figure 3, le circuit imprimé du boîtier pourra comprendre des inserts filetés IF destinés à recevoir les filetages des vis de fixation VF, et permettant un meilleur serrage de ces vis pour améliorer encore la conduction thermique entre le circuit Cl et le boîtier support CH. Les intercalaires thermiques IT pourront alors par exemple être collés sur la face inférieure du circuit imprimé, de manière à simplifier encore l'opération d'assemblage.

En variante, le boîtier support CH pourra encore comprendre un organe de prépositionnement NV destiné prépositionner circuit imprimé Cl en le plaquant à la face intérieure du boîtier support. Ainsi, les filetages du circuit imprimé sont suffisamment proches des trous du boîtier support, lorsque l'opérateur, ou une machine spéciale, monte les vis de fixation VF. Cet organe de positionnement pourra par exemple être une nervure interne NV telle que représentée dans la vue en coupe, placée dans le fond du boîtier et ayant un contour externe qui appuie sur le circuit imprimé pour le guider, lorsque celui-ci atteint le fond du boîtier support. Une telle nervure pourra alors faire partie intégrante du boîtier dans le cas d'une réalisation de celui-ci par moulage.

Comme on le voit, le boîtier selon l'invention est adapté à divers circuit électroniques et il a un coût de fabrication qui est réduit par diminution du nombre de pièces primaires. Il est notamment très adapté au cas des circuits imprimés comportant des composants de puissance dégageant une quantité de chaleur importante, et devant être implantés dans un environnement sévère.

## Revendications

1. Boîtier électronique comprenant un boîtier support métallique (CH) fermé de façon étanche, un circuit imprimé (Cl) muni de composants électroniques (CP) inséré à l'intérieur du boîtier support et un intercalaire thermique disposé entre le circuit imprimé et une face intérieure du boîtier support, le circuit imprimé étant plaqué contre ladite face intérieure du boîtier support par au moins une vis de telle manière que la chaleur produite par les composants électroniques puisse être transférée par conduction thermique du circuit imprimé (Cl) vers le boîtier support par l'intermédiaire de l'intercalaire thermique (IT), **caractérisé en ce** chaque vis (VF) est insérée dans le circuit imprimé depuis l'extérieur du boîtier support, chaque vis traversant de façon étanche ladite face intérieure du boîtier.

2. Le boîtier électronique selon la revendication 1, dans lequel chaque vis est insérée dans un insert métallique fileté (IF) fixé audit circuit imprimé.

3. Le boîtier électronique selon la revendication 1 ou 2, dans lequel le boîtier support (CH) comprend au moins une nervure interne (NV) perpendiculaire à ladite face intérieure du boîtier support, chaque nervure étant agencée pour guider ledit circuit imprimé de telle manière à le plaquer contre ladite face intérieure quand il est inséré dans ledit boîtier support (CH).
